# EUROPEAN PATENT APPLICATION

(11) **EP 4 583 674 A1**
(43) Date of publication of application: **09.07.2025**
(21) Application number: 23914508.9
(22) Date of filing: 19.12.2023
(51) Int. Cl.: H10K 59/12, C09J 11/08, C08F 222/14, C08F 220/28, C08F 220/30

(54) **LIGHT ADJUSTING PACKAGING COMPOSITION FOR OLED, AND PACKAGING FILM AND PREPARATION METHOD THEREFOR**

(30) Priority: 06.01.2023 CN 202310017245
(71) Applicant: Xi'an Smart Materials Co., Ltd., Xi'an, Shaanxi 712099 (CN)
(72) Inventor: HE, Xin, Xi'an, Shaanxi 712099 (CN); LI, Huanle, Xi'an, Shaanxi 712099 (CN); YAO, Linyan, Xi'an, Shaanxi 712099 (CN); SHI, Yangyang, Xi'an, Shaanxi 712099 (CN)
(74) Representative: Zacco GmbH
(86) International application number: PCT/CN2023/139987
(87) International publication number: WO 2024/146375

(57) **Abstract**

Provided is a light adjusting packaging composition, including a photocurable glue composition and scattering particles. The scattering particles account for 1-10 wt% of the total weight of the light adjusting packaging composition, and a refractive index difference between the photocurable glue composition and the scattering particles is less than 0.2. Polysiloxane microspheres having an average particle size of 0.1-2 µm are dispersed in the photocurable glue composition, and when the refractive index of the polysiloxane microspheres is less than the refractive index of the photocurable glue composition, a light adjusting packaging film having a light scattering function can be formed. The manufacturing process of the packaging film prepared from the light adjusting packaging composition is simple, and the packaging film is mainly suitable for a top-emitting OLED light-emitting device, such that the light deviation of the OLED caused by different observation angles is avoided, and the light diffusion effect is improved.

## Description

The present application claims the priority of Chinese patent application 202310017245.4, filed on January 6, 2023. The present application incorporates the entirety of the above-mentioned Chinese patent application.

### Technical Field

The present application relates to the technical field of optical films, in particular to a light adjusting packaging composition for an OLED, a packaging film and a preparation method therefor.

### Background

An Organic Light-emitting Diode (OLED) has the advantages of active light-emitting, good temperature characteristics, low power consumption, fast response, bendability, ultra-lightness and ultra-thinness, low cost and the like, and is thus rapidly applied as a new generation of display technology. The OLED can be divided into three types according to the light-emitting direction: a bottom-emitting OLED, a top-emitting OLED and a double-sided-emitting OLED, wherein the top-emitting OLED refers to an OLED in which light is emitted from the top of the device, the top-emitting OLED can improve the device efficiency, narrow the spectrum and the color purity, but the electroluminescent spectrum of the OLED changes with the observation angle, resulting in light color deviation of the OLED due to different observation angles. Therefore, a light adjusting film can be introduced into a film packaging layer to adjust the light color deviation.

In a conventional light adjusting film, inorganic scattering particles with different refractive indexes are added into a transparent base material, the mixture is coated on a base material by means of inkjet printing or the like, and is photocured to obtain the light adjusting film. Common inorganic particles are SiO₂, TiO₂, Al₂O₃, CaCO₃, BaSO₄ and the like, and the disadvantage is that the refractive index is high and the density is large, which causes poor transparency and poor diffusion effect of the light adjusting film.

The main technical parameters of the light adjusting film include the light transmittance and the haze. The light transmittance represents the overall utilization rate of the light adjusting film to the incident light, and the haze represents the degree of deviation of the incident light from the original incident direction. Therefore, the light transmittance and the haze are used to characterize the diffusion degree of the incident light introduced by the light adjusting film. However, for the light adjusting film based on inorganic or organic particles, the increase of the haze will inevitably cause the decrease of the light transmittance. In addition, the viscosity of the prepared photocuring composition is small, the dispersion effect of the organic/inorganic particle photocuring composition is poor, and there is agglomeration phenomenon, thereby affecting the light dispersion effect.

In view of this, the present applicant provides a light adjusting packaging composition for an OLED, a packaging film and a preparation method therefor to overcome the defects of the prior art.

### Summary

An objective of the present application is to overcome the defects of the prior art, and provides a light adjusting packaging composition for an OLED, a packaging film and a preparation method therefor, so as to solve the problem of light deviation due to different observation angles when the OLED emits light from the top, which affects the light efficiency and the light diffusion effect.

The objective of the present application is achieved by the following technical solutions.

In one aspect, the present application provides a light adjusting packaging composition for an OLED, which includes a photocurable glue composition and scattering particles, the scattering particles account for 1-10 wt% of the total weight of the light adjusting packaging composition, and the refractive index of the scattering particles is less than the refractive index of the photocurable glue composition.

Furthermore, a refractive index difference between the photocurable glue composition and the scattering particles is less than 0.2.

Preferably, a refractive index of the scattering particles is 1.3-1.45.

Preferably, a refractive index of the photocurable glue composition is 1.45-1.55.

Furthermore, the scattering particles are polymer particles, preferably polysiloxane microspheres, and an average particle size of the polysiloxane microsphere particles is 0.1-2 µm.

When the light emitted from the organic light-emitting diode is visible light and is incident on the scattering particles, the particle size of the scattering particles needs to be 0.1-2 µm, which not only can improve the light efficiency, but also can improve the light diffusion effect. This is because when the particle size of the scattering particles is less than 0.1 µm, the light generally does not scatter, but can be completely internally emitted, so that the light efficiency cannot be effectively improved. However, when the particle size of the scattering material is greater than 2 µm, the particle size is close to the thickness of an organic layer, so that the scattering particles are not easy to disperse, and because the viscosity of the photocurable glue composition is small, when the particle size of the scattering particles is too large, the scattering particles cannot be stably stored due to gravity.

Further, the refractive index of the scattering material is selected to be 1.3-1.45, because when the refractive index of the scattering material is less than 1.3, the transparency of the cured light adjusting encapsulation composition is poor, and when the refractive index is greater than 1.45, the light diffusion effect is poor, the light emitted from the organic light-emitting diode will pass through the polysiloxane microspheres, undergoing refraction inside the polysiloxane microspheres which tends to concentrate the light, so that the diffusion effect through the center of the particles is poor.

Furthermore, the refractive index of the photocurable glue composition of the present application is 1.45-1.55, and the refractive index difference between the photocurable glue composition and the scattering particles is less than 0.2. This is because when the refractive index difference between the photocurable glue composition and the scattering particles is less than 0.2, the scattering angle of the light incident on the scattering particles is small, and the scattering phenomenon occurs to a greater extent, so that the light diffusion effect is improved, and when the refractive index difference between the two is greater than 0.2, that is, the refractive index of the scattering particles is too small, the light transmittance of the cured photocurable glue composition is poor.

Furthermore, the photocurable glue composition includes, in parts by weight, 10-40 parts of a monofunctional photocurable monomer, 20-50 parts of a bifunctional photocurable monomer, 2-10 parts of a multifunctional photocurable monomer, and 0.5-8 parts of a photoinitiator.

Furthermore, the monofunctional photocurable monomer, the bifunctional photocurable monomer, and the multifunctional photocurable monomer are each selected from (methyl)acrylates.

Furthermore, the monofunctional photocurable monomer is selected from compounds having an alicyclic group or an aromatic group and having one (methyl)acrylate in the molecular structure. Specifically, the monofunctional photocurable monomer is at least one of polyethylene glycol o-phenylphenyl ether acrylate, 2-(m-tolyloxy)ethyl acrylate, 2-(3-methoxyphenoxy)ethyl acrylate, dicyclopentenyloxyethyl acrylate, dicyclopentenyl acrylate, 2-(2-naphthoxy)ethyl methacrylate, o-phenylphenoxyethyl(methyl)acrylate, 2-(p-cumyl-phenoxy)-ethyl acrylate, or isobornyl(methyl)acrylate.

Furthermore, the difunctional photocurable monomer is selected from di(methyl)acrylates containing C6-C15 alkylene groups. Specifically, the difunctional photocurable monomer can be selected from at least one of 1,6-hexanediol di(methyl)acrylate, 1,8-octanediol di(methyl)acrylate, 1,9-nonanediol di(methyl)acrylate, 1,10-decanediol di(methyl)acrylate, 1,11-undecanediol di(methyl)acrylate, or 1,12-dodecanediol di(methyl)acrylate.

Furthermore, the multifunctional photocurable monomer is selected from one or more of trimethylolpropane triacrylate, ditrimethylolpropane tetraacrylate, pentaerythritol tetraacrylate, dipentaerythritol pentaacrylate, or dipentaerythritol hexaacrylate.

Furthermore, the photoinitiator is a free radical initiator. The free radical initiator is at least one of a triazine-based, an acetophenone-based, a benzophenone-based, a thioxanthone-based, a benzoin-based, a phosphorous-based, or an oxime-based photoinitiator.

Preferably, the photoinitiator used in the present application is a phosphorous-based photoinitiator. Specifically, the phosphorous-based photoinitiator is one or more of diphenyl(2,4,6-trimethylbenzoyl)phosphine oxide, benzyl(diphenyl)phosphine oxide, or bis(2,6-dimethoxybenzoyl)(2,4,4-trimethylpentyl)phosphine oxide.

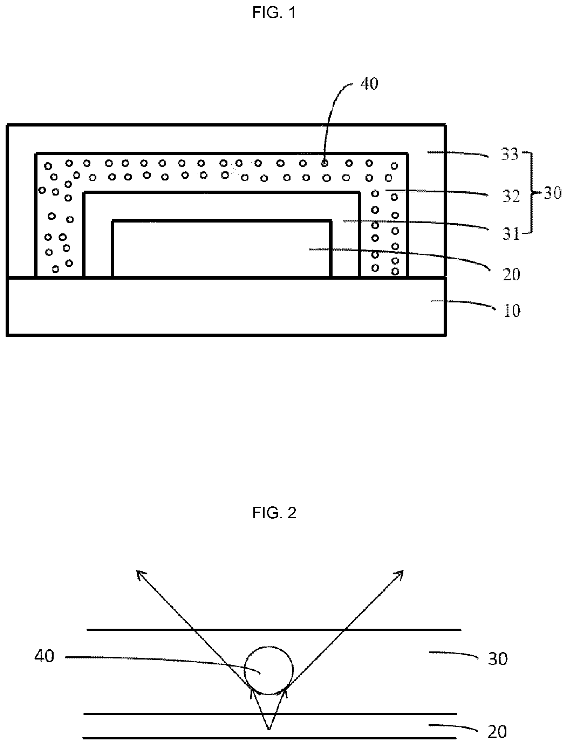

The second aspect of the present application provides a packaging film, which can be used in an organic light-emitting diode display device as shown in FIG. 1. The packaging film includes a first inorganic layer, an organic layer, and a second inorganic layer, wherein the organic layer is located between the first inorganic layer and the second inorganic layer, the organic layer is obtained by photocuring the light adjusting packaging composition described above, a the thickness of the organic layer is 3-25 µm, the first inorganic layer and the second inorganic layer are made of any one of metal oxides, metal nitrides, or metal sulfides, and the total thickness of the first inorganic layer and the second inorganic layer is 100-300 nm.

Furthermore, the packaging film can include a plurality of organic layers and inorganic layers arranged alternately.

The third aspect of the present application also provides a preparation method for the packaging film, which includes the following specific steps:
step one, preparation of the light adjusting packaging composition: adding the above-mentioned photocurable glue composition and scattering particles into a light-proof bottle, mixing uniformly, and filtering to obtain the light adjusting packaging composition, wherein a viscosity of the composition is 15-30 cps at 25°C, and a surface tension is 15-38 mN/m, thereby meeting the requirement of inkjet printing;
step two, preparation of the inorganic layer: coating an inorganic layer material on the surface of an object to be packaged by CVD (chemical vapor deposition) technology to form the inorganic layer;
step three, preparation of the organic layer: coating the light adjusting packaging composition obtained in step one on the surface of the inorganic layer prepared in step two by inkjet printing, and then irradiating with 10 mW/cm²-70 mW/cm² ultraviolet light for 10-100 seconds to cure and form the organic layer;
step four, preparation of the packaging film: depositing and coating the surface of the object to be packaged in the mode of the inorganic layer-organic layer-inorganic layer alternately, and the outermost layer being the inorganic layer, and finally the inorganic layer-organic layer-inorganic layer deposited and coated on the surface of the object to be packaged being the packaging film.

Compared with the prior art, the present application has the beneficial effects as follows:
1. In the present application, the light adjusting packaging composition of the present application is compounded with scattering particles with a particle size of 0.1-2 µm and a refractive index of 1.3-1.45 and a photocurable glue composition with a lower refractive index. The light efficiency of the cured light adjusting packaging composition is improved, and the light diffusion effect is improved.
2. In the present application, the polysiloxane microspheres are dispersed in the photocurable glue composition, the polysiloxane microspheres can be uniformly dispersed in the system and integrated without phase separation, porosity or cracking occurring, the cured light adjusting packaging composition has large haze and high transparency, and has excellent light diffusion effect.
3. The present application employs the synergistic effect of the mono(methyl)acrylate with an alicyclic group or an aromatic group, the di(methyl)acrylate containing C6-C15 alkylene groups and the multifunctional(methyl)acrylate, which can effectively reduce the water vapor transmission rate, improve the light transmittance and haze of the packaging film, and the stability of the light adjusting packaging composition is high.
4. The polysiloxane microspheres adopted in the present application are dispersed in the photocurable glue composition, and a light adjusting packaging film having a light scattering function can be formed. The manufacturing process of the prepared packaging film is simple, and the packaging film is mainly suitable for the top-emitting OLED light-emitting device, such that the light deviation of the OLED caused by different observation angles is avoided, and the light diffusion effect is excellent.

### Brief Description of the Drawings

The accompanying drawings are incorporated into and constitute a part of the present specification, and illustrate principles of the present application together with the specification.

To provide a clearer explanation of the technical solutions in the embodiments of the present application or the prior art, a brief introduction will be given below to the accompanying drawings required for the embodiments or the prior art description. Obviously, those skilled in the art can obtain other drawings according to these drawings without creative labor.
FIG. 1 is a cross-sectional view of an organic light-emitting diode display device;
FIG. 2 is a light reflection diagram according to light incident to scattering particles;

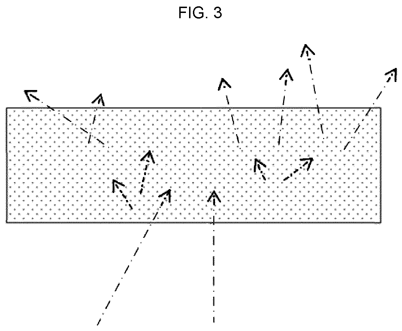

FIG. 3 is a light diffusion effect diagram of light in an organic layer.

10 is a substrate, 20 is an organic light-emitting diode, 31 is a first inorganic layer, 32 is an organic layer, 33 is a second inorganic layer, 30 is a packaging film, and 40 is scattering particles.

### Detailed Description of the Embodiments

Herein, exemplary embodiments will be described in detail, with examples shown in the accompanying drawings. When the following description involves the accompanying drawings, unless otherwise indicated, the same numbers in different drawings represent the same or similar elements. The embodiments described in the following exemplary embodiments do not represent all the embodiments consistent with the present application. On the contrary, they are only examples of devices consistent with some aspects of the present application as described in the accompanying claims.

To enable those skilled in the art to better understand the technical solution of the present application, a further detailed description of the present application is provided below in conjunction with the accompanying drawings and examples.

### Example 1

The present example provided a light adjusting packaging composition for an OLED, which included a photocurable glue composition and scattering particles as raw materials, and the scattering particles accounted for 7% of the total weight of the light adjusting packaging composition.

Specifically, the scattering particles in the present example were polysiloxane microspheres with a refractive index of 1.430 and an average particle size of 1 µm, and were commercially available from ETERNAL SPECIALTY MAT ZHUHAI CO LTD.

The photocurable glue composition in the present example included 20 parts of a monofunctional photocurable monomer, 30 parts of a bifunctional photocurable monomer, 8 parts of a multifunctional photocurable monomer, and 3 parts of a photoinitiator.

Specifically, the monofunctional photocurable monomer was dicyclopentenyloxyethyl acrylate (CAS No.: 65983-31-5); the bifunctional photocurable monomer was 1,12-dodecanediol di(methyl)acrylate (CAS No.: 72829-09-5); the multifunctional photocurable monomer was pentaerythritol tetraacrylate (CAS No.: 4986-89-4); and the photoinitiator was photoinitiator TPO (CAS No.: 75980-60-8).

The present example also provided a preparation method for the light adjusting packaging composition, which included the steps that: the monofunctional photocurable monomer, the bifunctional photocurable monomer, the multifunctional photocurable monomer, the photoinitiator, and the scattering particles in the above-mentioned proportions were added into a light-proof bottle, mixed uniformly, and filtered to obtain the light adjusting packaging composition.

A viscosity of the photocurable glue composition prepared in the present example was 23.4 cps, a surface tension was 29.1 mN/m, and a refractive index was 1.512.

The photocuring process was as follows: 25°C, 30 mW/cm², a curing time of 60 s, and a curing light intensity center wavelength of 395 nm.

### Example 2

The present example provided a light adjusting packaging composition for an OLED, which included a photocurable glue composition and scattering particles as raw materials, and the scattering particles accounted for 3% of the total weight of the light adjusting packaging composition.

Specifically, the scattering particles in the present example were polysiloxane microspheres with a refractive index of 1.430 and an average particle size of 1 µm, and were commercially available from ETERNAL SPECIALTY MAT ZHUHAI CO LTD.

The photocurable glue composition in the present example included 40 parts of a monofunctional photocurable monomer, 50 parts of a bifunctional photocurable monomer, 3 parts of a multifunctional photocurable monomer, and 5 parts of a photoinitiator.

Specifically, the monofunctional photocurable monomer was o-phenylphenoxyethyl acrylate (CAS No.: 91442-24-9); the bifunctional photocurable monomer was 1,12-dodecanediol di(methyl)acrylate (CAS No.: 72829-09-5); the multifunctional photocurable monomer was pentaerythritol tetraacrylate (CAS No.: 4986-89-4); and the photoinitiator was photoinitiator TPO (CAS No.: 75980-60-8).

The present example also provided a preparation method for the light adjusting packaging composition, which included the steps that: the monofunctional photocurable monomer, the bifunctional photocurable monomer, the multifunctional photocurable monomer, the photoinitiator, and the scattering particles in the above-mentioned proportions were added into a light-proof bottle, mixed uniformly, and filtered to obtain the light adjusting packaging composition.

A viscosity of the photocurable glue composition prepared in the present example was 20.1 cps, a surface tension was 27.4 mN/m, and a refractive index was 1.503.

The photocuring process was as follows: 25°C, 30 mW/cm², a curing time of 60 s, and a curing light intensity center wavelength of 395 nm.

### Example 3

The present example provided a light adjusting packaging composition for an OLED, which included a photocurable glue composition and scattering particles as raw materials, and the scattering particles accounted for 10% of the total weight of the light adjusting packaging composition.

Specifically, the scattering particles in the present example were polysiloxane microspheres with a refractive index of 1.430 and an average particle size of 2 µm, and were commercially available from ETERNAL SPECIALTY MAT ZHUHAI CO LTD.

The photocurable glue composition in the present example included 10 parts of a monofunctional photocurable monomer, 25 parts of a bifunctional photocurable monomer, 2 parts of a multifunctional photocurable monomer, and 1 part of a photoinitiator.

Specifically, the monofunctional photocurable monomer was o-phenylphenoxyethyl acrylate (CAS No.: 91442-24-9); the bifunctional photocurable monomer was 1,12-dodecanediol di(methyl)acrylate (CAS No.: 72829-09-5); the multifunctional photocurable monomer was pentaerythritol tetraacrylate (CAS No.: 4986-89-4); and the photoinitiator was photoinitiator TPO (CAS No.: 75980-60-8).

The present example also provided a preparation method for the light adjusting packaging composition, which included the steps that: the monofunctional photocurable monomer, the bifunctional photocurable monomer, the multifunctional photocurable monomer, the photoinitiator, and the scattering particles in the above-mentioned proportions were added into a light-proof bottle, mixed uniformly, and filtered to obtain the light adjusting packaging composition.

A viscosity of the photocurable glue composition prepared in the present example was 24.8 cps, a surface tension was 28.1 mN/m, and a refractive index was 1.514.

The photocuring process was as follows: 25°C, 30 mW/cm², a curing time of 60 s, and a curing light intensity center wavelength of 395 nm.

### Comparative Example 1

The specific embodiment of Comparative Example 1 was the same as that of Example 1, except that the scattering particles in Comparative Example 1 were titanium dioxide having a refractive index of 2.6 and an average particle size of 1 µm, and were purchased from Ningbo Jiweina New Material Technology Co., Ltd.

### Comparative Example 2

The specific embodiment of Comparative Example 2 was the same as that of Example 1, except that the monofunctional photocurable monomer was not added in Comparative Example 2.

### Comparative Example 3

The specific embodiment of Comparative Example 3 was the same as that of Example 1, except that the bifunctional photocurable monomer was not added in Comparative Example 3.

### Comparative Example 4

The specific embodiment of Comparative Example 4 was the same as that of Example 1, except that the multifunctional photocurable monomer was not added in Comparative Example 4.

### Performance test:

(1) Water vapor transmission rate: A water vapor transmission rate tester (PERMATRAN-W3/33, manufactured by MOCON) was used to measure the water vapor transmission rate at 85°C and 85% relative humidity for 24 hours.
(2) Stability: The light adjusting packaging compositions prepared in Examples 1-3 and Comparative Examples 1-2 were placed in colorimetric tubes of the same specification, 3 mL of liquid at a position 5 mm below a liquid surface was weighed at 0 day and 3 days respectively, and a weight ratio of the 3 mL of liquid placed for 3 days to that placed for 0 day was calculated to characterize the stability of the system.
(3) Light transmittance: The light transmittance of the cured light adjusting packaging composition in a visible light range of 600 nm was measured by an UV spectrophotometer.
(4) Haze: The haze of the cured light adjusting packaging composition at a wavelength of 600 nm was measured by a haze meter, wherein a thickness of the cured light adjusting packaging composition was 18 µm.

The performance test results were shown in Table 1 below.

**Table 1**

| | Water vapor transmission rate (g/m² 24 h) | Stability | Light transmittance | Haze |
|---|---|---|---|---|
| Example 1 | 4.0 | 0.97 | 91.4 | 10.9 |
| Example 2 | 4.1 | 0.93 | 93.2 | 10.6 |
| Example 3 | 4.3 | 0.96 | 92.8 | 10.5 |
| Comparative Example 1 | 6.1 | 0.81 | 86.3 | 3.4 |
| Comparative Example 2 | 8.4 | 0.84 | 88.5 | 7.5 |
| Comparative Example 3 | 6.7 | 0.80 | 85.1 | 6.6 |
| Comparative Example 4 | 8.8 | 0.75 | 87.8 | 8.4 |

As shown in Table 1, in Examples 1-3, the light adjusting packaging composition was a mixture of the photocurable glue composition and the scattering particles, the scattering particles were the polysiloxane microspheres with a designed refractive index, and a refractive index difference between the scattering particles and the photocurable glue composition was less than 0.2. When the photocurable glue composition was a mixture of the monofunctional, bifunctional and multifunctional photocurable monomers and the photoinitiator in a set ratio, a water vapor transmission rate of the finally formed packaging film was less than 4.5 g/m²·24 h, a stability was greater than 0.9, a light transmittance was greater than 90%, and a haze was greater than 10. In contrast, in Comparative Example 1, when the scattering particles were titanium dioxide with a refractive index of 2.6, or in Comparative Examples 2 to 4, when the photocurable glue composition did not contain any of monofunctional, bifunctional and multifunctional photocurable monomer, the water vapor transmission rate, the stability, the light transmittance and the haze data all performed poorly, and therefore the packaging film was difficult to be used in the OLED.

The above description is only a specific embodiment of the present application, which enables those skilled in the art to understand or implement the present application. Various modifications to these embodiments will be apparent to those skilled in the art, and the general principles defined herein can be implemented in other embodiments without departing from the spirit or scope of the present application.

It should be understood that the present application is not limited to the content already described above, and various modifications and changes can be made without departing from the scope thereof. The scope of the present application is limited only by the appended claims.

## Claims

1. A light adjusting packaging composition for an OLED, wherein the light adjusting packaging composition comprises a photocurable glue composition and scattering particles, the scattering particles account for 1-10 wt% of the total weight of the light adjusting packaging composition, and the refractive index of the scattering particles is less than the refractive index of the photocurable glue composition.

2. The light adjusting packaging composition for the OLED according to claim 1, wherein a refractive index difference between the photocurable glue composition and the scattering particles is less than 0.2.

3. The light adjusting packaging composition for the OLED according to claim 1, wherein a refractive index of the scattering particles is 1.3-1.45.

4. The light adjusting packaging composition for the OLED according to claim 1, wherein the scattering particles are polymer particles, and an average particle size of the polymer particles is 0.1-2 µm.

5. The light adjusting packaging composition for the OLED according to claim 1, wherein the photocurable glue composition comprises, in parts by weight, 10-40 parts of a monofunctional photocurable monomer, 20-50 parts of a bifunctional photocurable monomer, 2-10 parts of a multifunctional photocurable monomer, and 0.5-8 parts of a photoinitiator.

6. The light adjusting packaging composition for the OLED according to claim 5, wherein the monofunctional photocurable monomer, the bifunctional photocurable monomer, and the multifunctional photocurable monomer are each selected from (methyl)acrylates.

7. The light adjusting packaging composition for the OLED according to claim 6, wherein the monofunctional photocurable monomer is selected from compounds having an alicyclic group or an aromatic group and having one (methyl)acrylate in the molecular structure.

8. The light adjusting packaging composition for the OLED according to claim 7, wherein the monofunctional photocurable monomer is at least one of polyethylene glycol o-phenylphenyl ether acrylate, 2-(m-tolyloxy)ethyl acrylate, 2-(3-methoxyphenoxy)ethyl acrylate, dicyclopentenyloxyethyl acrylate, dicyclopentenyl acrylate, 2-(2-naphthoxy)ethyl methacrylate, o-phenylphenoxyethyl(methyl)acrylate, 2-(p-cumyl-phenoxy)-ethyl acrylate, or isobornyl(methyl)acrylate.

9. A packaging film, wherein the packaging film comprises a first inorganic layer (31), an organic layer (32), and a second inorganic layer (33), wherein the organic layer (32) is located between the first inorganic layer (31) and the second inorganic layer (33), the organic layer (32) is obtained by photocuring the light adjusting packaging composition according to any one of claims 1-8, a thickness of the organic layer (32) is 3-25 µm, and the total thickness of the first inorganic layer (31) and the second inorganic layer (33) is 100-300 nm.

10. A method for preparing the packaging film according to claim 9, wherein the method comprises the following specific steps:
step one, preparation of the light adjusting packaging composition: adding the photocurable glue composition and the scattering particles according to any one of claims 1-8 into a light-proof bottle, mixing uniformly, and filtering to obtain the light adjusting packaging composition;
step two, preparation of the inorganic layer: coating an inorganic layer material on the surface of an object to be packaged by chemical vapor deposition technology to form the inorganic layer;
step three, preparation of the organic layer: coating the light adjusting packaging composition obtained in step one on the surface of the inorganic layer prepared in step two by inkjet printing, and then irradiating with 10 mW/cm²-70 mW/cm² ultraviolet light for 10-100 seconds to cure and form the organic layer;
step four, preparation of the packaging film: depositing and coating the surface of the object to be packaged in the mode of the inorganic layer-organic layer-inorganic layer alternately, and the outermost layer being the inorganic layer, and finally the inorganic layer-organic layer-inorganic layer deposited and coated on the surface of the object to be packaged being the packaging film.
